# EUROPEAN PATENT APPLICATION

(11) **EP 4 600 734 A1**
(43) Date of publication of application: **13.08.2025**
(21) Application number: 25152419.5
(22) Date of filing: 17.01.2025
(51) Int. Cl.: G03F 1/24, G03F 7/09

(54) **PATTERN FORMING METHOD AND LAMINATE**

(30) Priority: 31.01.2024 JP 2024012989
(71) Applicant: Shin-Etsu Chemical Co., Ltd., Tokyo 100-0005 (JP)
(72) Inventor: Kobayashi, Naoki, Niigata (JP); Ishiwata, Kenta, Niigata (JP); Takizawa, Kanata, Niigata (JP)
(74) Representative: Sonnenhauser, Thomas Martin

(57) **Abstract**

The present invention is a pattern forming method using EUV lithography, the pattern forming method including steps of: forming a resist upper layer film on at least one surface side of a substrate; irradiating the resist upper layer film with EUV light; and developing the resist upper layer film to form a pattern, wherein a multilayer reflective film layer is disposed between the substrate and the resist upper layer film, and the multilayer reflective film layer has a structure in which two or more materials different in refractive index n at a wavelength of the EUV light are alternately laminated. The present invention provides: a pattern forming method and a laminate that can contribute to sensitivity enhancement while maintaining LWR of a resist upper layer film are provided.

## Description

### TECHNICAL FIELD

The present invention relates to a pattern forming method and a laminate.

### BACKGROUND ART

With higher integration and higher processing speed of LSIs, finer pattern rules have been rapidly developed. In particular, logic devices for use in smartphones and the like have driven miniaturization, and 10 nm-node logic devices have been manufactured using a multiple exposure process by ArF lithography (multi-patterning lithography).

The next 7 nm-node and 5 nm-node lithography faces problems such as cost increase due to multiple exposure and accuracy in registration in multiple exposure. The advent of EUV lithography that can reduce the number of times of exposure has been expected.

Extreme ultra violet (EUV) with a wavelength of 13.5 nm have a wavelength more than one-tenth as short as ArF excimer laser beams with a wavelength of 193 nm. EUV lithography is therefore expected to provide high resolution because of high light contrast. Since EUV beams have a short wavelength and a high energy density, an acid generator is sensitized by a small amount of photons. The number of photons in EUV exposure is said to be 1/14 of that of ArF exposure. In EUV exposure, degradation in line width roughness (LWR) and in hole critical dimension uniformity (CDU) caused by fluctuations of photons has been considered as a problem (Non Patent Document 1). It has been pointed out that such degradation may be caused by localization and agglomeration of a base polymer and an acid generator as well as diffusion of acids generated from an acid generator.

To cope with this, for example, lowering the post exposure bake (PEB) temperature may reduce LWR but reduces the sensitivity of EUV resist. Further, increasing the amount of quencher can reduce LWR, but this method also leads to lower sensitivity. For practical use of EUV resist, it is necessary to overcome the trade-off between sensitivity and LWR.

Various studies have been conducted for the above problem. Patent Document 1 reports a high-sensitivity multilayer resist film in which a metal layer, which when exposed, enhances radiation light to a resist layer, is disposed on the resist layer in order to enhance the sensitivity of EUV resist. Patent Document 2 reports a method for forming a pattern using a resist underlayer film containing a sensitizer that absorbs EUV beams and generates secondary electrons. However, these methods using secondary electrons are difficult to control and may cause deterioration of resist shapes.

### CITATION LIST

### PATENT LITERATURE

Patent Document 1: JP 2021-508071 A
Patent Document 2: JP 5705103 B

### NON PATENT LITERATURE

Non Patent Document 1: SPIE Vol.3331 p.531 (1998)

### SUMMARY OF INVENTION

### TECHNICAL PROBLEM

Many problems have to be solved for practical use of EUV lithography as a mass production process for semiconductor devices. One of properties that need improvement is to enhance sensitivity while maintaining LWR.

The present invention is made in view of the above situations, and an object of the present invention is to provide a pattern forming method that can contribute to sensitivity enhancement while maintaining LWR of a resist upper layer film, and a laminate.

### SOLUTION TO PROBLEM

To achieve the object, the present invention provides a pattern forming method using EUV lithography, the pattern forming method includes steps of:
forming a resist upper layer film on at least one surface side of a substrate;
irradiating the resist upper layer film with EUV light; and
developing the resist upper layer film to form a pattern, wherein
a multilayer reflective film layer is disposed between the substrate and the resist upper layer film, and
the multilayer reflective film layer has a structure in which two or more materials different in refractive index n at a wavelength of the EUV light are alternately laminated.

Such a pattern forming method can contribute to sensitivity enhancement while maintaining LWR of the resist upper layer film.

In the present invention, it is preferable that the multilayer reflective film layer includes a structure in which two or more materials different in refractive index n by 0.01 or more at a wavelength of the EUV light are alternately laminated.

The pattern forming method using a multilayer reflective film layer with such a structure can contribute to sensitivity enhancement while maintaining LWR of the resist upper layer film.

In the present invention, it is preferable that the multilayer reflective film layer includes: one layer or two or more layers of a high refractive index film made of a material containing Si and one or more elements selected from nitrogen, carbon, hydrogen, and oxygen; and one layer or two or more layers of a low refractive index film made of a material containing any one or more metals of Ti, Cr, Ni, Zr, Nb, Mo, Ru, Rh, Hf, Ta, W, and Bi.

The pattern forming method using a multilayer reflective film layer with such a structure can increase the reflectivity for EUV light and therefore can contribute to sensitivity enhancement while maintaining LWR of the resist upper layer film.

In the present invention, it is preferable that the multilayer reflective film layer includes: one layer or two or more layers of a high refractive index film made of a material containing carbon and one or more elements selected from nitrogen, hydrogen, and oxygen; and one layer or two or more layers of a low refractive index film made of a material containing any one or more metals of Ti, Cr, Ni, Zr, Nb, Mo, Ru, Rh, Hf, Ta, W, and Bi.

The pattern forming method using a multilayer reflective film layer with such a structure can increase the reflectivity for EUV light and therefore can contribute to sensitivity enhancement while maintaining LWR of the resist upper layer film.

In the present invention, it is preferable that the multilayer reflective film layer has two or more layers of a low refractive index film made of a material containing any one or more metals of Ti, Cr, Ni, Zr, Nb, Mo, Ru, Rh, Hf, Ta, W, and Bi.

The pattern forming method using a multilayer reflective film layer with such a structure can increase the reflectivity for EUV light and therefore can contribute to sensitivity enhancement while maintaining LWR of the resist upper layer film.

In this case, it is preferable that the low refractive index film has a refractive index n of 0.97 or less at a wavelength of the EUV light.

Using a film with such a refractive index can increase the reflectivity for EUV light.

In this case, it is preferable that the low refractive index film has a film thickness of 10 nm or less per layer.

The multilayer reflective film layer having such a low refractive index film can increase the reflectivity for EUV light.

In the present invention, it is preferable that at least one or more layers of an adhesive film are disposed between the resist upper layer film and the multilayer reflective film layer, the adhesive film is selected from: a silicon-containing hard mask film made of a material containing Si and one or more elements selected from nitrogen, carbon, hydrogen, and oxygen; and a carbon-containing hard mask film made of a material containing carbon and one or more elements selected from nitrogen, hydrogen, and oxygen.

The adhesive film selected from the silicon-containing hard mask film and the carbon-containing hard mask film between the resist upper layer film and the multilayer reflective film layer can enhance the effect of preventing collapse of the resist upper layer film pattern, and the accuracy of pattern transfer to the layer to be processed.

In the present invention, it is preferable that the pattern forming method further includes a step of transferring a pattern up to a layer to be processed on the substrate by dry etching while using the resist upper layer film having the pattern as a mask.

With such a pattern forming method, a fine pattern can be formed in a target to be processed (substrate) with high accuracy.

Further, the present invention provides a laminate including: a substrate to be processed in which a pattern is to be formed; a multilayer reflective film layer on the substrate to be processed; and a resist upper layer film on the multilayer reflective film layer, wherein the multilayer reflective film layer has a structure in which two or more materials different in refractive index n at a wavelength of EUV light are alternately laminated.

Such a laminate can enhance sensitivity while maintaining LWR of the resist upper layer film when pattern formation is performed.

### ADVANTAGEOUS EFFECTS OF INVENTION

As described above, with the pattern forming method according to the present invention, EUV light can be effectively utilized in photolithography because of the multilayer reflective film layer having a high reflectivity for EUV light. Therefore, in EUV lithography using EUV light as exposure light, higher sensitivity can be achieved while maintaining the LWR performance that the resist upper layer film intrinsically has.

### BRIEF DESCRIPTION OF DRAWINGS

FIG. 1 is an illustration of a pattern forming method (processing of a layer to be processed) according to an embodiment of the present invention;
FIG. 2A is an illustration of a multilayer reflective film layer in the pattern forming method according to an embodiment of the present invention;
FIG. 2B is an illustration of a multilayer reflective film layer in the pattern forming method according to an embodiment of the present invention;
FIG. 2C is an illustration of a multilayer reflective film layer in the pattern forming method according to an embodiment of the present invention;
FIG. 2D is an illustration of a multilayer reflective film layer in the pattern forming method according to an embodiment of the present invention; and
FIG. 3 is an illustration of an example of a conventional pattern forming method (tri-layer process).

### DESCRIPTION OF EMBODIMENTS

As described above, in a fine patterning process using a multilayer resist method, there has been a need for developing a pattern forming method that can contribute to sensitivity enhancement while maintaining LWR of a resist upper layer film, and a laminate.

The inventors of the present invention have noted a multilayer reflective film layer that can reflect EUV light, and conducted elaborate studies. As a result, the inventors have found that a structure including a multilayer reflective film layer in which two or more materials different in refractive index n at the wavelength of EUV light are laminated between a resist upper layer film and a substrate can achieve higher sensitivity while maintaining the LWR performance that the resist upper layer film intrinsically has, in EUV lithography using EUV light as exposure light. This finding has led to completion of the present invention.

Specifically, the present invention provides a pattern forming method using EUV lithography, the pattern forming method includes steps of:
forming a resist upper layer film on at least one surface side of a substrate;
irradiating the resist upper layer film with EUV light; and
developing the resist upper layer film to form a pattern, wherein
a multilayer reflective film layer is disposed between the substrate and the resist upper layer film, and
the multilayer reflective film layer has a structure in which two or more materials different in refractive index n at a wavelength of the EUV light are alternately laminated.

Further, the present invention provides a laminate including: a substrate to be processed in which a pattern is to be formed; a multilayer reflective film layer on the substrate to be processed; and a resist upper layer film on the multilayer reflective film layer, wherein the multilayer reflective film layer has a structure in which two or more materials different in refractive index n at a wavelength of EUV light are alternately laminated.

Hereinafter, the present invention will be specifically described. However, the present invention is not limited these examples.

### <Laminate>

A laminate according to the present invention includes: a substrate to be processed in which a pattern is to be formed; a multilayer reflective film layer on the substrate to be processed; and a resist upper layer film on the multilayer reflective film layer, wherein the multilayer reflective film layer has a structure in which two or more materials different in refractive index n at a wavelength of EUV light are alternately laminated.

The substrate to be processed, the multilayer reflective film layer, and the resist upper layer film used in the laminate according to the present invention can be the same as those used in the pattern forming method according to the present invention described later.

### <Pattern Forming Method Using Multilayer Reflective Film Layer>

The present invention provides a pattern forming method using EUV lithography. The pattern forming method includes steps of:
forming a resist upper layer film on at least one surface side of a substrate;
irradiating the resist upper layer film with EUV light; and
developing the resist upper layer film to form a pattern, wherein
a multilayer reflective film layer is disposed between the substrate and the resist upper layer film, and
the multilayer reflective film layer has a structure in which two or more materials different in refractive index n at a wavelength of the EUV light are alternately laminated.

With such a pattern forming method, the sensitivity of the resist upper layer film can be enhanced because of a high reflectivity for EUV light.

In the pattern forming method described above, the resist upper layer film may be either a positive type or a negative type, and the same photoresist composition as those commonly used can be used as a composition for forming a resist upper layer film. The photoresist composition may contain metal atoms such as Sn, In, Ga, Ge, Al, Ce, La, Cs, Zr, Hf, Ti, Bi, Sb, and Zn. When a resist upper layer film is formed with the above photoresist composition, the resist upper layer film may be formed by a spin coating method or by vapor deposition such as a CVD method or an ALD method.

When the resist upper layer film is formed by a spin coating method, prebake is performed after photoresist composition application, preferably at 60 to 180°C for 10 to 300 seconds. Thereafter, exposure, post-exposure bake (PEB), and development are performed according to the ordinary method to obtain a resist upper layer film pattern. The thickness of the resist upper layer film is preferably, but not limited to, 10 to 500 nm, particularly preferably 20 to 400 nm.

When the resist upper layer film is formed by vapor deposition such as a CVD method or an ALD method, the resist upper layer film can be an EUV light-sensitive metal oxide-containing film, wherein the metal is selected from Sn, Zr, Hf, Ti, Bi, Sb, and the like, and among those, Sn excellent in EUV light sensitivity is preferred. The metal oxide-containing film may be a film containing a photosensitive organic metal oxide such as an organotin oxide (for example, haloalkyl Sn, alkoxyalkyl Sn, or amidoalkyl Sn). Some specific examples of suitable precursors include trimethyltin chloride, dimethyletin dichloride, methyltin trichloride, tris(dimethylamino)methyl tin(IV), and (dimethylamino)trimethyl tin(IV).

The metal oxide-containing film may be deposited by PECVD or PEALD, for example, using Lam Vector (registered trademark) tool. In the ALD implementation, the Sn oxide precursor is separated from O precursor/plasma. Deposition temperature is preferably in the range from 50°C to 600°C. Deposition pressure is preferably between 100 and 6,000 mTorr. Precursor liquid flow (for example, organotin oxide precursor) for the metal oxide-containing film may be 0.01 to 10 cmm, and gas flow rate (CO₂, CO, Ar, N₂) may be 100 to 10,000 sccm. Plasma power may be 200 to 1,000 W per 300 mm wafer station, using a high frequency plasma (for example, 13.56 MHz, 27.1 MHz, or higher frequency). Deposited thickness is preferably 100 to 2,000 Å.

The wavelength of EUV light for use in EUV lithography using EUV light as exposure light is preferably 13 to 14 nm. Light with a wavelength of about 13.5 nm is more preferred.

The development method in the pattern forming method is preferably alkaline development or development by an organic solvent.

The substrate (substrate to be processed) is not particularly limited, and a substrate of Si, α-Si, p-Si, SiO₂, SiN, SiON, W, TiN, or Al, or the substrate with a layer to be processed formed thereon is used. As the layer to be processed, for example, a variety of low-k films of Si, SiO₂, SiON, SiN, p-Si, α-Si, W, W-Si, Al, Cu, Al-Si, and the like and a stopper film thereof are used, and the layer may be formed to a thickness of typically 50 to 10,000 nm, particularly 100 to 5,000 nm. When the layer to be processed is formed, the substrate and the layer to be processed are of different materials.

A substate for semiconductor fabrication on which a metal film, a metal carbide film, a metal oxide film, a metal nitride film, a composite thereof, or the like is formed as the layer to be processed (portion to be processed) can be used as the substrate.

A silicon substrate is commonly used as the substrate for semiconductor fabrication. However, the substrate is not particularly limited to this, and a substrate of a material different from that of the layer to be processed, such as Si, amorphous silicon (α-Si), p-Si, SiO₂, SiN, SiON, W, TiN, or Al, may be used.

Silicon, titanium, tungsten, hafnium, zirconium, chromium, germanium, copper, aluminum, or iron, or an alloy thereof can be used as a metal that constitutes the layer to be processed. As the layer to be processed containing such a metal, for example, Si, SiO₂, SiN, SiON, SiOC, p-Si, α-Si, TiN, WSi, BPSG, SOG, Cr, CrO, CrON, MoSi, W, W-Si, Al, Cu, Al-Si, and a variety of low dielectric constant films and an etching stopper film thereof may be used and formed to a thickness of typically 50 to 10,000 nm, particularly 100 to 5,000 nm.

In order to increase the reflectivity for EUV light, the pattern forming method according to the present invention uses the multilayer reflective film layer having a structure in which two or more materials different in refractive index n at a wavelength of the EUV light are alternately laminated.

Refractive index n in the EUV region can be determined according to B. L. Henke, E. M. Gullikson and J. C. Davis, X-ray interactions: photoabsorption, scattering, transmission and reflection at E=50-30,000 eV, Z=1-92, Atomic Data and Nuclear Data Tables Vol. 54 (No.2), 181-342 (July 1993). In actuality, a web page <http://henke.lbl.gov/optical_constants/getdb2.html> from CXRO (The Center for X-ray Optics) was used for calculation of specific numerical values.

It is preferable to use the multilayer reflective film layer having a structure in which two or more materials different in refractive index n by 0.01 or more at a wavelength of the EUV light are alternately laminated.

When the refractive index n of the multilayer reflective film layer varies by 0.01 or more, the reflectivity for EUV light is increased and the sensitivity of the resist can be improved in EUV lithography using EUV light as exposure light.

The difference in refractive index n in the multilayer reflective film layer is preferably 0.01 or more, more preferably 0.02 or more, even more preferably 0.03 or more, particularly preferably 0.04 or more. The upper limit is preferably 0.15 or less, more preferably 0.1 or less.

As long as the difference in refractive index n in the multilayer reflective film layer is 0.01 or more, the kind of film (constituent element ratio) in each layer may be the same or different, but it is preferable that the kind of film in each layer is the same in view of etching processing.

It is preferable that the multilayer reflective film layer has one layer or two or more layers of a high refractive index film made of a material containing Si and one or more elements selected from nitrogen, carbon, hydrogen, and oxygen, and one layer or two or more layers of a low refractive index film made of a material containing any one or more metals of Ti, Cr, Ni, Zr, Nb, Mo, Ru, Rh, Hf, Ta, W, and Bi.

The high refractive index film containing Si is preferably a film made of a material containing Si and one or more elements selected from nitrogen, carbon, hydrogen, and oxygen, and the Si content in the high refractive index film is preferably 10% by mass or more. The Si content is more preferably 15% by mass or more, even more preferably 20% by mass or more, particularly preferably 30% by mass or more.

A higher Si content is preferable in order to increase the refractive index n.

A polysiloxane-based silicon-containing resist middle layer film, or an inorganic hard mask middle layer film selected from, a silicon oxide film, a silicon nitride film, and a silicon oxynitride film can be used as the high refractive index film containing Si. When an inorganic hard mask middle layer film is formed, a silicon oxide film, a silicon nitride film, or a silicon oxynitride film (SiON film) can be formed by a CVD method, an ALD method, or the like. For example, a method of forming a silicon nitride film is disclosed in JP 2002-334869 A and WO 2004/066377 A1.

When the high refractive index film containing Si is formed by a spin coating method, it is preferable to evaporate a solvent after spin coating and perform baking (heat treatment) for accelerating a crosslinking reaction to prevent mixing with the upper layer film. Baking is performed preferably in a range of 100°C to 600°C and 10 to 600 seconds, more preferably in a range of 200°C to 500°C and 10 to 300 seconds. Considering the effects on device damage and wafer deformation, the upper limit of heating temperature in a wafer process in lithography is preferably 600°C or lower, more preferably 500°C or lower.

It is preferable that the multilayer reflective film layer has one layer or two or more layers of a high refractive index film made of a material containing carbon and one or more elements selected from nitrogen, hydrogen, and oxygen, and one layer or two or more layers of a low refractive index film made of a material containing any one or more metals of Ti, Cr, Ni, Zr, Nb, Mo, Ru, Rh, Hf, Ta, W, and Bi.

The high refractive index film containing carbon is preferably a film made of a material containing carbon and one or more elements selected from nitrogen, hydrogen, and oxygen, and the carbon content in the high refractive index film is preferably 60% by mass or more, more preferably 70% by mass or more, even more preferably 80% by mass or more, particularly preferably 85% by mass or more.

A higher carbon content is preferable in order to increase the refractive index n.

Application-type resist underlayer film materials can be used for the high refractive index film containing carbon. Examples of the application-type resist underlayer film materials include resins and compositions described in WO 2007/105776 A1, WO 2009/072465 A1, WO 2010/061774 A1, WO 2010/147155 A1, WO 2011/125839 A1, WO 2012/050064 A1, WO 2012/077640 A1, WO 2013/005797 A1, WO 2013/047106 A1, WO 2013/047516 A1, WO 2013/080929 A1, WO 2013/115097 A1, WO 2013/146670 A1, WO 2014/024836 A1, WO 2014/208324 A1, WO 2014/208499 A1, WO 2015/170736 A1, WO 2015/194273 A1, WO 2016/147989 A1, JP 2001-040293 A, JP 2002-214777 A, JP 2002-296789 A, JP 2004-205685 A, JP 2004-264710 A, JP 2005-043471 A, JP 2005-250434 A, JP 2005-128509 A, JP 2006-259249 A, JP 2006-285046 A, JP 2007-171895 A, JP 2007-199653 A, JP 2007-293294 A, JP 2008-065303 A, JP 2008-065081 A, JP 2008-274250 A, JP 2009-014816 A, JP 2009-229666 A, JP 2009-251130 A, JP 2010-122656 A, JP 2010-015112 A, JP 2010-271654 A, JP 2011-107684 A, JP 2011-170059 A, JP 2012-001687 A, JP 2012-077295 A, JP 2012-214720 A, JP 2012-215842 A, JP 2013-083939 A, JP 2014-024831 A, JP 2014-157169 A, JP 2015-131954 A, JP 2015-183406 A, JP 2016-029160 A, JP 2016-044272 A, JP 2016-060886 A, JP 2016-145849 A, JP 2016-167047 A, JP 2016-216367 A, JP 2017-003959 A, JP 2017-119670 A, JP 2017-119671 A, JP 2013-516643 A, JP 2015-515112 A, and JP 2019-044022 A. In the present invention, it is preferable to use a resin containing an aromatic skeleton-containing compound such as a naphthalene skeleton-containing compound, a fluorene skeleton-containing compound, a carbazole skeleton-containing compound, an acenaphthylene skeleton-containing compound, a naphthol skeleton-containing compound, and a bisnaphthol skeleton-containing compound.

When the high refractive index film containing carbon is formed by a spin coating method, it is preferable to evaporate a solvent after spin coating and perform baking (heat treatment) for accelerating a crosslinking reaction to prevent mixing with the upper layer film. Baking is performed preferably in a range of 100°C to 600°C and 10 to 600 seconds, more preferably in a range of 200°C to 500°C and 10 to 300 seconds. Considering the effects on device damage and wafer deformation, the upper limit of heating temperature in a wafer process in lithography is preferably 600°C or lower, more preferably 500°C or lower.

Alternatively, a resist underlayer film can also be formed as the high refractive index film containing carbon by applying a composition for forming a resist underlayer film onto a layer to be processed by a spin coating method or the like in the same manner as described above, and baking and curing the composition for forming a resist underlayer film in an atmosphere with an oxygen concentration of 0.1% by volume to 21% by volume.

Baking the composition for forming a resist underlayer film in such an oxygen atmosphere can produce a sufficiently cured resist underlayer film. The atmosphere during baking may be in the air, but preferably filled with an inert gas such as N₂, Ar, and He for reducing oxygen in order to prevent oxidation of the resist underlayer film. The oxygen concentration needs to be controlled in order to prevent oxidation and is preferably 1,000 ppm or less, more preferably 100 ppm or less (volumetric basis). Preventing oxidation is preferred, because if so increase in absorption or decrease in etching resistance is prevented.

Further, amorphous carbon, diamond-like carbon, or the like formed by a PVD method, a CVD method, or an ALD method can also be used.

It is preferable that the multilayer reflective film layer includes two or more layers of a low refractive index film made of a material containing any one or more metals of Ti, Cr, Ni, Zr, Nb, Mo, Ru, Rh, Hf, Ta, W, and Bi.

It is more preferable that the high refractive index film included in the multilayer reflective film layer is a material containing carbon and one or more elements selected from nitrogen, hydrogen, and oxygen, in terms of etching selectivity with a metal-containing film serving as the low refractive index film.

The low refractive index film made of a material containing any one or more metals of Ti, Cr, Ni, Zr, Nb, Mo, Ru, Rh, Hf, Ta, W, and Bi can be formed by a spin coating method, a PVD (physical vapor deposition) method, a CVD (chemical vapor deposition) method, an ALD (atomic layer deposition) method, or the like.

The low refractive index film containing metal is not limited as long as it contains any one or more metals of Ti, Cr, Ni, Zr, Nb, Mo, Ru, Rh, Hf, Ta, W, and Bi. The low refractive index film may be a film of metal alone, or may contain one or more elements selected from nitrogen, carbon, and oxygen in addition to the metal. Examples include metal-containing films containing two or more elements selected from nitrogen, carbon, and oxygen, such as oxide film, nitride film, carbide film, oxycarbide film, and oxynitride film containing any of the above metals. The metal-containing film may contain different kinds of metals, and in this case, the metal-containing film is preferably a metal-containing film containing two metal elements.

Such a metal-containing film can further improve the reflectivity because a metal-containing film with a low refractive index n at EUV light can be provided as the low refractive index film.

The low refractive index film containing metal is preferably an amorphous film. An amorphous film is preferred because when it is etched, the line width roughness (LWR) of the pattern is not degraded.

When a metal oxide film is used as the low refractive index film, a spin coating method using a composition for forming a metal-containing film described later is preferably used in terms of productivity. When a film of metal alone, a metal nitride film, a metal carbide film, or the like is used as the low refractive index film, it is preferable to use a PVD method, a CVD method, or an ALD method.

When a spin coating method is used, the solvent is evaporated after spin coating, and baking (heat treatment) for accelerating a crosslinking reaction is performed to prevent mixing with the resist upper layer film or the resist middle layer film. Baking is performed preferably in a range of 100°C to 600°C and 10 to 600 seconds, more preferably in a range of 200°C to 500°C and 10 to 300 seconds. Considering the effects on device damage and wafer deformation, the upper limit of heating temperature in a wafer process in lithography is preferably 600°C or lower, more preferably 500°C or lower.

Alternatively, the metal-containing film can also be formed by applying a composition for forming a metal-containing film by a spin coating method or the like in the same manner as described above, and baking and curing the composition for forming a metal-containing film in an atmosphere with an oxygen concentration of 0.1% by volume to 21% by volume.

Baking the composition for forming a metal-containing film in such an oxygen atmosphere can produce a sufficiently cured metal-containing film. The atmosphere during baking may be in the air, but preferably filled with an inert gas such as N₂, Ar, and He for reducing oxygen in order to prevent oxidation of the metal-containing film. The oxygen concentration needs to be controlled in order to prevent oxidation and is preferably 1,000 ppm or less, more preferably 100 ppm or less (volumetric basis). Preventing oxidation of the metal-containing film during baking is preferred, because if so increase in absorption or decrease in etching resistance is prevented.

Examples of the composition for forming a metal-containing film are as follows.

### <Composition for Forming Metal-Containing Film>

It is preferable that the composition for forming a metal-containing film contains (A) a metal compound and (B) a solvent, and the metal compound (A) contains any one or more metals of Ti, Cr, Ni, Zr, Nb, Mo, Ru, Rh, Hf, Ta, W, and Bi. The composition for forming a metal-containing film may contain optional components according to the purpose of the present invention. The components will be described below.

### <(A) Metal Compound>

The metal compound (A) is not limited, and any known metal compound, either organic or inorganic, can be used. The metal compound is preferably a metal salt, a metal complex, or a combination thereof. The metal salt and the metal complex include hydrate.

It is preferable that the metal compound (A) contains any one or more metals of Ti, Cr, Ni, Zr, Nb, Mo, Ru, Rh, Hf, Ta, W, and Bi. When metal atoms in the metal compound (A) are any of the elements above, a metal-containing film formed from the composition for forming a metal-containing film has a low refractive index for EUV light. The metal atoms may be atoms of one element or may be atoms of two or more elements, but it is preferable that the metal atoms are atoms of one element in that it is desired that the etching rate in metal-containing film etching transfer processing after forming a fine pattern is uniform in plane on the order of nanometer.

It is preferable that components other than the metal atoms that constitute the metal compound (A) include one or more a hydrolyzable group, or one or more ligands derived from a compound containing one or more kinds selected from an organic acid (hereinafter also referred to as "organic acid (a)"), hydroxy acid ester, β-diketone, β-keto ester, α,α-dicarboxylic acid ester, amine, amide, olefin, hydrocarbon containing π-bond, and diphosphine. Here the "organic acid" is an acidic organic compound, and the "organic compound" is a compound having at least one carbon atom.

Examples of the hydrolyzable group include halogen atom, alkoxy group, and acyloxy group.

Examples of the halogen atom include fluorine, chlorine, bromine, and iodine atoms.

The alkoxy group is preferably an alkoxy group having 1 to 10 carbon atoms, and examples of the alkoxy group may include methoxy, ethoxy, n-propoxy, i-propoxy, butoxy, and octyloxy groups.

Examples of the acyloxy group may include acetoxy, ethylyloxy, propionyloxy, butyryloxy, t-butyryloxy, t-amylyloxy, n-hexanecarbonyloxy, and n-octanecarbonyloxy groups.

The hydrolyzable group is preferably alkoxy group or acyloxy group, more preferably n-propoxy group, i-propoxy group, butoxy group, or octyloxy group.

Examples of the organic acid (a) include carboxylic acid, sulfonic acid, sulfinic acid, organic phosphinic acid, organic phosphonic acid, phenols, enol, thiol, acid imide, oxime, and sulfonamide.

Examples of the carboxylic acid include monocarboxylic acids such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid, and shikimic acid; dicarboxylic acids such as oxalic acid, malonic acid, maleic acid, methylmalonic acid, fumaric acid, adipic acid, sebacic acid, phthalic acid, and tartaric acid; and carboxylic acids having three or more carboxy groups such as citric acid.

Examples of the sulfonic acid include benzenesulfonic acid and p-toluenesulfonic acid.

Examples of the sulfinic acid include benzenesulfinic acid and p-toluenesulfinic acid.

Examples of the organic phosphinic acid include diethylphosphinic acid, methylphenylphosphinic acid, and diphenylphosphinic acid.

Examples of the organic phosphonic acid include methylphosphonic acid, ethylphosphonic acid, t-butylphosphonic acid, cyclohexylphosphonic acid, and phenylphosphonic acid.

Examples of the phenols include monovalent phenols such as phenol, cresol, 2,6-xylenol, and naphthol; divalent phenols such as catechol, resorcinol, hydroquinone, and 1,2-naphthalenediol; and phenols having a valency of three or more, such as pyrogallol and 2,3,6-naphthalenetriol.

Examples of the enol include 2-hydroxy-3-methyl-2-butene and 3-hydroxy-4-methyl-3-hexene.

Examples of the thiol include mercaptoethanol and mercaptopropanol.

Examples of the acid imide include carboxylic imides such as maleimide and succinimide; and sulfonic imides such as di(trifluoromethanesulfonic acid) imide and di(pentafluoroethanesulfonic acid) imide.

Examples of the oxime include aldoximes such as benzaldoxime and salicylaldoxime; and ketoximes such as diethylketoxime, methylethylketoxime, and cyclohexanoneoxime.

Examples of the sulfonamide include methylsulfonamide, ethylsulfonamide, benzenesulfonamide, and toluenesulfonamide.

The organic acid (a) is preferably carboxylic acid having 1 to 10 carbon atoms.

Examples of the hydroxy acid ester include glycolic acid ester, lactic acid ester, 2-hydroxycyclohexane-1-carboxylic acid ester, and salicylic acid ester.

Examples of the β-diketone include 2,4-pentanedione, 3-methyl-2,4-pentanedione, and 3-ethyl-2,4-pentanedione.

Examples of the β-keto ester include acetoacetic acid ester, α-alkyl-substituted acetoacetic acid ester, β-ketopentanoic acid ester, benzoylacetic acid ester, and 1,3-acetonedicarboxylic acid ester.

Examples of the α,α-dicarboxylic acid ester include malonic acid diester, α-alkyl-substituted malonic acid diester, α-cycloalkyl-substituted malonic acid diester, and α-aryl-substituted malonic acid diester.

Examples of an amine compound include pyridine, trimethylamine, piperidine, diethanolamine, and triethanolamine.

Examples of a compound containing amide include compounds including unsubstituted amide (NH₂), methylamide (NHMe), dimethylamide (NMe₂), diethylamide (NEt₂), dipropylamide (NPr₂), and the like.

Examples of a compound containing olefin include linear olefins such as ethylene and propylene; and cyclic olefins such as cyclopentene, cyclohexene, and norbornene.

Examples of the hydrocarbon having π bond include: linear dienes such as butadiene and isoprene; cyclic dienes such as cyclopentadiene, methylcyclopentadiene, pentamethylcyclopentadiene, cyclohexadiene, and norbornadiene; and aromatic hydrocarbons such as benzene, toluene, xylene, hexamethylbenzene, naphthalene, and indene.

Examples of the diphosphine include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, and 1,1'-bis(diphenylphosphino)ferrocene.

Preferred examples of the metal compound (A) may be as follows.

Examples of a Ti-containing compound include diisopropoxybis(2,4-pentanedionato) titanium(IV), tetra-n-butoxy titanium(IV), tetra-n-propoxy titanium(IV), tetra-isopropoxy titanium(IV), titanium(IV) tri-n-butoxymonostearate, tetrakis(2-ethylhexyl) orthotitanate, dihydroxybis(hydrogen lactato) titanium(IV), titanium(IV) butoxide oligomer, aminopropyltrimethoxy titanium(IV), triethoxymono(2,4-pentanedionato) titanium(IV), tri-n-propoxymono(2,4-pentanedionato) titanium(IV), triisopropoxymono(2,4-pentanedionato) titanium, and di-n-butoxybis(2,4-pentanedionato) titanium(IV).

Examples of a Cr-containing compound include chromium(III) tris(2-ethylhexanoate), tris(2,4-pentanedionato)chromium(III), tris(trifluoro-2,4-pentanedionato)chromium(III), chromium(III) pyridine-2-carboxylate, chromium(III) chloride, and chromium(II) chloride.

Examples of a Ni-containing compound include nickel(II) acetate, nickel chloride, nickel(II) 2-ethylhexanoate, bis(2,4-pentanedionato)nickel(II) hydrate, bis(hexafluoroacetylacetonato)nickel(II), nickel(II) 2-amino-5-methylbenzenesulfonate, and nickel(II) trifluoromethanesulfonate.

Examples of a Zr-containing compound include dibutoxybis(ethylacetoacetate) zirconium(IV), di-n-butoxybis(2,4-pentanedionato) zirconium(IV), tetra-n-butoxy zirconium(IV), tetra-n-propoxy zirconium(IV), tetraisopropoxy zirconium(IV), aminopropyltriethoxy zirconium(IV), 2-(3,4-epoxycyclohexyl)ethyltrimethoxy zirconium(IV), γ-glycidoxypropyltrimethoxy zirconium(IV), 3-isocyanopropyltrimethoxy zirconium(IV), triethoxymono(2,4-pentanedionato) zirconium(IV), tri-n-propoxymono(2,4-pentanedionato) zirconium(IV), triisopropoxymono(2,4-pentanedionato) zirconium(IV), tri(3-methacryloxypropyl)methoxy zirconium(IV), tri(3-acryloxypropyl)methoxy zirconium(IV), zirconium(IV) acetate, zirconium(IV) acetate oxide, zirconium(II) bis(2-ethylhexanoate), zirconium(IV) tetra(2-ethylhexanoate), bis(2-ethylhexanoic acid)oxozirconium(IV), zirconium nitrate, and zirconium(IV) chloride.

Examples of a Nb-containing compound include niobium(V) ethoxide, niobium n-butoxide, niobium phenoxide, tetrakis(2,2,6,6-tetramethyl-3,5-heptanedionato)niobium(IV), pentakis(dimethylamino)niobium(V), niobium(V) chloride, niobium(V) fluoride, triacetic acid niobium(III), and niobium(IV) 2-ethylhexanoate.

Examples of a Mo-containing compound include pentaethoxymolybdenum(V), molybdenum(VI) hexaethoxide, molybdenum(V) isopropoxide, molybdenum(II) acetate dimer, molybdenum(IV) oxide bis(acetylacetonate), molybdenum(VI) oxide bis(2,2,6,6-tetramethyl-3,5-heptanedionate), molybdenum 2-ethylhexanoate, molybdenum(V) chloride, and molybdenum(III) chloride.

Examples of a Ru-containing compound include diacetato[(S)-(-)-2,2'-bis(diphenylphosphino)-1,1'-binaphthyl] ruthenium(II), tris(2,4-pentanedionato)ruthenium(III), bis(2,2,6,6-tetramethyl-3,5-heptanedionato)(1,5-cyclooctadiene)ruthenium (II), ruthenium(III) chloride, bis(ethylcyclopentadienyl)ruthenium(II), dichloro(1,5-cyclooctadiene)ruthenium(II), and pentamethylcyclopentadienylruthenium(III) chloride polymer.

Examples of a Rh-containing compound include acetylacetonatobis(ethylene)rhodium(I), (acetylacetonato)(norbornadiene)rhodium(I), dirhodium(II) tetraacetate, tetrakis(octanoato)dirhodium(II), rhodium(III) chloride, rhodium(III) nitrate, rhodium(II) acetate dimer, rhodium(II) trimethylacetate dimer, rhodium(II) trifluoroacetate dimer, rhodium(II) octanoate dimer, rhodium(II) triphenylacetate dimer, acetylacetonatobis(ethylene)rhodium(I), (acetylacetonato)(norbornadiene)rhodium(I), and (acetylacetonato)(1,5-cyclooctadiene)rhodium(I).

Examples of a Hf-containing compound include diisopropoxybis(2,4-pentanedionato) hafnium(IV), tetrabutoxy hafnium(IV), tetraisopropoxy hafnium(IV), tetraethoxy hafnium(IV), dichlorobis(cyclopentadienyl) hafnium(IV), hafnium(IV) chloride, tetrakis(dimethylamido)hafnium(IV), tetrakis(ethylmethylamido)hafnium(IV), hafnium carboxyethyl acrylate, bis(cyclopentadienyl)hafnium(IV) dichloride, and hafnium(IV) trifluoromethanesulfonate hydrate.

Examples of a Ta-containing compound include tantalum(V) methoxide, tantalum(V) ethoxide, tetrabutoxy tantalum(IV), pentabutoxy tantalum(V), pentaethoxy tantalum(V), tantalum(V) chloride, pentakis(dimethylamino)tantalum(V), tris(diethylamido) (tert-butylimido)tantalum(V), and tantalum(II) bis(2-ethylhexanoate).

Examples of a W-containing compound include tungsten(VI) ethoxide, tetrabutoxy tungsten(IV), pentabutoxy tungsten(V), pentamethoxy tungsten(V), hexabutoxy tungsten(VI), hexaethoxy tungsten(VI), and dichlorobis(cyclopentadienyl)tungsten(IV).

Examples of a Bi-containing compound include bismuth(III)-n-butoxide, tri-t-amiloxybismuth(III), triethoxybismuth(III), bismuth(III) tris(β-diketonate), bismuth(III) neodecanoate, tris(2-naphthol) bismuth(III), bismuth(III) fluoride, bismuth(III) bromide, bismuth(III) iodide, bismuth(III) oxychloride, bismuth(III) acetate, bismuth(III) subsalicylate, bismuth(III) 2-ethylhexanoate, and bismuth(III) trifluoromethanesulfonate.

Specific examples of the metal compound (A) include a compound represented by the following general formula (A-1). By using such a metal compound (A-1), the composition for forming a metal-containing film including the metal compound (A-1) can form a stable metal-containing film, and dry etching resistance can be improved.

LₐM(=O)_{b}X_{c} (A-1)

In the general formula (A-1), M is any one or more of Ti, Cr, Ni, Zr, Nb, Mo, Ru, Rh, Hf, Ta, W, and Bi; L is a monodentate ligand or multidentate ligand having 0 to 30 carbon atoms; X is a hydrolyzable group selected from halogen atom, alkoxy group, carboxylate group, acyloxy group, and -NR^{A}R^{B}, where R^{A} and R^{B} each independently represent a hydrogen atom or a monovalent organic group having 1 to 20 carbon atoms; and a+c is an integer of 1 to 6, where "a" is an integer of 0 to 4, "b" is an integer of 0 to 2, and "c" is an integer of 0 to 6.

Examples of the hydrolyzable group X in the general formula (A-1) include halogen atom, alkoxy group, carboxylate group, acyloxy group, and -NR^{A}R^{B}. R^{A} and R^{B} each independently represent a hydrogen atom or a monovalent organic group having 1 to 20 carbon atoms.

Examples of the halogen atom include fluorine, chlorine, bromine, and iodine atoms.

Examples of the alkoxy group include methoxy, ethoxy, n-propoxy, i-propoxy, n-butoxy, and t-butoxy groups.

Examples of the carboxylate group include monocarboxylic acids such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid, and shikimic acid; dicarboxylic acids such as oxalic acid, malonic acid, maleic acid, methylmalonic acid, fumaric acid, adipic acid, sebacic acid, phthalic acid and tartaric acid; and carboxylic acids having three or more carboxylate groups such as citric acid.

Examples of the acyloxy group may include acetoxy, ethylyloxy, propionyloxy, butyryloxy, t-butyryloxy, t-amylyloxy, n-hexanecarbonyloxy, and n-octanecarbonyloxy groups.

Examples of the -NR^{A}R^{B} include unsubtituted amino, methylamino, dimethylamino, diethylamino, and dipropylamino groups.

The hydrolyzable group X is preferably alkoxy group, more preferably i-propoxy group, n-butoxy group, or t-butoxy group.

L in the general formula (A-1) is a monodentate ligand or multidentate ligand having 0 to 30 carbon atoms.

### (Monodentate Ligand)

Examples of the monodentate ligand include hydroxo, carboxy, amide, amine, and olefin ligands.

Examples of the carboxy ligand include ligands derived from monocarboxylic acids such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid, and shikimic acid; ligands derived from dicarboxylic acids such as oxalic acid, malonic acid, maleic acid, methylmalonic acid, fumaric acid, adipic acid, sebacic acid, phthalic acid, and tartaric acid; and ligands derived from carboxylic acids having three or more carboxy groups such as citric acid.

Examples of the amide ligand include unsubstituted amide (NH₂), methylamide (NHMe), dimethylamide (NMe₂), diethylamide (NEt₂), and dipropylamide (NPr₂) ligands.

Examples of the amine ligand include pyridine, trimethylamine, and piperidine ligands.

Examples of the olefin ligand include linear olefins such as ethylene and propylene; and cyclic olefins such as cyclopentene, cyclohexene, and norbornene.

### (Multidentate Ligand)

Examples of the multidentate ligand include ligand derived from hydroxy acid ester, ligand derived from β-diketone, ligand derived from β-keto ester, ligand derived from α,α-dicarboxylic acid ester, hydrocarbon having π-bond, and diphosphine.

Examples of the hydroxy acid ester include glycolic acid ester, lactic acid ester, 2-hydroxycyclohexane-1-carboxylic acid ester, and salicylic acid ester.

Examples of the β-diketone include 2,4-pentanedione, 3-methyl-2,4-pentanedione, and 3-ethyl-2,4-pentanedione.

Examples of the β-keto ester include acetoacetic acid ester, α-alkyl-substituted acetoacetic acid ester, β-ketopentanoic acid ester, benzoylacetic acid ester, and 1,3-acetonedicarboxylic acid ester.

Examples of the α,α-dicarboxylic acid ester include malonic acid diester, α-alkyl-substituted malonic acid diester, α-cycloalkyl-substituted malonic acid diester, and α-aryl-substituted malonic acid diester.

Examples of the hydrocarbon having π bond include linear dienes such as butadiene and isoprene; cyclic dienes such as cyclopentadiene, methylcyclopentadiene, pentamethylcyclopentadiene, cyclohexadiene, and norbornadiene; and aromatic hydrocarbons such as benzene, toluene, xylene, hexamethylbenzene, naphthalene, and indene.

Examples of the diphosphine include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, and 1,1'-bis(diphenylphosphino)ferrocene.

The metal compound (A) may be, for example, a compound containing an inorganic anion such as an anion of oxoacid (phosphate ion, sulfate ion, chromate ion, tungstate ion (WO₄²⁻), molybdate ion (MoO₄²⁻), etc.) or a polyoxometalate anion in which a plurality of oxoacids are condensed, or a mixture thereof.

The polyoxometalate may be an isopolyoxometalate anion (M_{m'}O_{n'})^{c-} or a heteropolyoxometalate anion (X_{l'}M_{m'}O_{n'})^{c-}. In the above ion formulae, M represents a poly atom, X represents a hetero atom, m' represents the composition ratio of poly atoms, n' represents the composition ratio of oxygen atoms, and l' represents the composition ratio of hetero atoms. Examples of the poly atom M include Mo, W, Ti, and Nb. Examples of the hetero atom X include Si, P, As, S, Fe, and Co. The polyoxometalate may partially contain a counter cation such as Na⁺ or H⁺. Among those, in terms of excellent heat resistance, a polyoxometalate anion including at least one of tungsten (W) and molybdenum (Mo) is preferred.

Examples of the polyoxometalate anion including at least one of tungsten (W) and molybdenum (Mo) include isopolyoxometalates such as tungstate ion [W₁₀O₃₂]⁴⁻ and molybdate ion [Mo₆O₁₉]²⁻, and heteropolyoxometalates such as phosphotungstate ion [PW₁₂O₄₀]³⁻, [P₂W₁₈O₆₂]⁶⁻, silicotungstate ion [SiW₁₂O₄₀]⁴⁻, phosphomolybdate ion [PMo₁₂O₄₀]³⁻, silicomolybdate ion [SiMo₁₂O₄₀]⁴⁻, phosphotungstomolybdate ion [PW₁₂₋ₓMoₓO₄₀]³⁻ (x is an integer of 1 to 11), [P₂W_{18-y}Mo_{y}O₆₂]⁶⁻ (y is an integer of 1 to 17), and silicotungstomolybdate ion [SiW₁₂₋ₓMoₓO₄₀]⁴⁻(x is an integer of 1 to 11). Among those listed above, in terms of heat resistance and easy availability of raw materials, the polyoxometalate anion including at least one of tungsten (W) and molybdenum (Mo) is preferably a heteropolyoxometalate anion, even more preferably a heteropolyoxometalate anion containing phosphorus (P).

Furthermore, any one of the phosphotungstomolybdate ion [PW₁₀Mo₂O₄₀]³⁻, [PW₁₁Mo₁O₄₀]³⁻ and the phosphotungstate ion [PW₁₂O₄₀]³⁻ is even more preferred in terms of heat resistance.

The metal compounds (A) above may be used alone or in combination of two or more.

The metal compound (A) may contain one or two or more organic acids (a).

The metal compound (A) may be a hydrolysis reaction product of the metal compound containing a hydrolyzable group, a hydrolytic condensation reaction product of the metal compound containing a hydrolyzable group, or a combination thereof. As used herein "hydrolytic condensation reaction" refers to a reaction in which the hydrolyzable group of the metal compound is hydrolyzed and converted into -OH, and the resulting two -OH groups are dehydrated and condensed to form -O-.

Alternatively, a compound obtained by reacting any of these compounds with a compound that may serve as a monodentate ligand or a multidentate ligand through a ligand exchange reaction may be used. A hydrolytic condensation reaction product of the metal-containing compound having a hydrolyzable group, or a compound obtained by reacting a hydrolytic condensation reaction product of the metal-containing compound having a hydrolyzable group with a compound that may serve as a monodentate ligand or a multidentate ligand may be used.

### <(B) Solvent>

In the present invention, the solvent (B) that can be used in the composition for forming a metal-containing film is any solvent in which the metal compound (A) and other additives and the like contained are dissolved or dispersed.

Specifically, for example, the organic solvents disclosed in paragraphs [0091] to [0092] in JP 2007-199653 A can be added. More specifically, propylene glycol monomethyl ether acetate, propylene glycol monomethyl ether, propylene glycol monoethyl ether, propylene glycol monopropyl ether, 2-heptanone, cyclopentanone, cyclohexanone, and γ-butyrolactone, or a mixture containing one or more kinds of these is preferably used.

Other examples of the solvent that can be used include butanediol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl amyl ketone, propylene glycol dimethyl ether, diethylene glycol dimethyl ether, diamyl ether, isoamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, methyl isobutyl ketone, and cyclopentyl methyl ether.

The blending amount of the solvent (B) is preferably 200 to 10,000 parts by mass, more preferably 250 to 5,000 parts by mass with respect to 100 parts by mass of the metal compound (A).

### <(B1) High Boiling Point Solvent>

In the composition for forming a metal-containing film, the solvent (B) may include (B1) a high boiling point organic solvent.

The high boiling point organic solvent (B1) may be one or more organic solvents with a boiling point of 180°C or higher.

For example, a mixture of one or more organic solvents with a boiling point lower than 180°C and one or more organic solvents (high boiling point solvent (B1)) with a boiling point of 180°C or higher may be used as the solvent (B).

The high boiling point solvent (B1) is not limited to hydrocarbons, alcohols, ketones, esters, ethers, chlorinated solvents, and the like as long as it can dissolve or disperse each component of the composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexane diol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, and dibutyl adipate. These may be used singly or in mixture.

The high boiling point solvent (B1) may be selected as appropriate, for example, from those listed above, in accordance with the temperature at which the composition for forming a metal-containing film is thermally treated. The boiling point of the high boiling point solvent (B1) is preferably 180°C to 300°C, even more preferably 200°C to 300°C. Such boiling points can prevent too fast evaporation in baking (heat treatment) and therefore can suppress defects due to dryness during film formation. In addition, such boiling points have no adverse effect on the film properties such as etching resistance, because the solvent is evaporated after baking and not left in the film.

When the high boiling point solvent (B1) is used, the blending amount is preferably 1 to 30 parts by mass with respect to 100 parts by mass of the organic solvent having a boiling point of lower than 180°C. Such blending amount is preferred to impart sufficient thermal flowability in baking and leave no solvent in the film, thereby preventing deterioration of film properties such as etching resistance.

### <Other Additives>

The composition for forming a metal-containing film may further include at least one or more selected from (C) a crosslinking agent, (D) an acid generator, and (E) a surfactant, if necessary.

Hereinafter, the components that may be included in the composition for forming a metal-containing film, other than the metal compound (A) and the solvent (B), will be described.

### (C) Crosslinking Agent

The composition for forming a metal-containing film may include (C) a crosslinking agent in order to increase curability and further suppress intermixing with the resist upper layer film. The crosslinking agent (C) is not limited and various known crosslinking agents can be widely used. Examples include melamine crosslinking agents, glycoluril crosslinking agents, benzoguanamine crosslinking agents, urea crosslinking agents, β-hydroxyalkylamide crosslinking agents, isocyanurate crosslinking agents, aziridine crosslinking agents, oxazoline crosslinking agents, epoxy crosslinking agents, and phenol crosslinking agents. The crosslinking agents (C) can be used alone or in combination of two or more. When the crosslinking agent (C) is added, the amount added is preferably 5 to 50 parts by mass, more preferably 10 to 40 parts by mass with respect to 100 parts by mass of the metal compound (A). If the amount added is 5 parts by mass or more, sufficient curability can be expressed, and intermixing with the resist upper layer film can be suppressed. On the other hand, if the amount added is 50 parts by mass or less, the proportion of the metal compound (A) in the composition is not decreased and therefore dry etching resistance is not deteriorated.

Specific examples of the melamine crosslinking agents include hexamethoxymethylated melamine, hexabutoxymethylated melamine, alkoxy- and/or hydroxy-substituted derivatives thereof, and partial self-condensates thereof.

Specific examples of the glycoluril crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea crosslinking agents include dimethoxymethylated dimethoxyethyleneurea, alkoxy- and/or hydroxy-substituted derivatives thereof, and partial self-condensates thereof.

Specific examples of the β-hydroxyalkylamide crosslinking agents include N,N,N',N'-tetra(2-hydroxyethyl)adipic acid amide.

Specific examples of the isocyanurate crosslinking agents include triglycidyl isocyanurate and triallyl isocyanurate.

Specific examples of the aziridine crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline crosslinking agents include 2,2'-isopropylidenebis(4-benzyl-2-oxazoline), 2,2'-isopropylidenebis(4-phenyl-2-oxazoline), 2,2'-methylenebis(4,5-diphenyl-2-oxazoline), 2,2'-methylenebis(4-phenyl-2-oxazoline), 2,2'-methylenebis(4-tert-butyl-2-oxazoline), 2,2'-bis(2-oxazoline), 1,3-phenylenebis(2-oxazoline), 1,4-phenylenebis(2-oxazoline), and 2-isopropenyloxazoline copolymer.

Specific examples of the epoxy crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Specific examples of the phenol crosslinking agents include a compound represented by the following general formula (10).

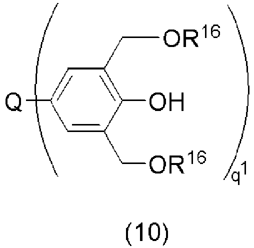

In the general formula (10), Q is a single bond or a hydrocarbon group with a valency of q¹ having 1 to 20 carbon atoms, R¹⁶ is a hydrogen atom or an alkyl group having 1 to 20 carbon atoms, and q¹ is an integer of 1 to 5.

In the general formula (10), Q is a single bond or a hydrocarbon group with a valency of q¹ having 1 to 20 carbon atoms, where q¹ is an integer of 1 to 5, preferably 2 or 3. Specific examples of Q include methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R¹⁶ is a hydrogen atom or an alkyl group having 1 to 20 carbon atoms. Specific examples of the alkyl group having 1 to 20 carbon atoms include methyl, ethyl, propyl, isopropyl, butyl, isobutyl, penthyl, isopenthyl, hexyl, octyl, ethylhexyl, decyl, and eicosanyl groups. A hydrogen atom or a methyl group is preferred.

Specific examples of the compound represented by the general formula (10) include the following compounds. Among these, hexamethoxymethylated products of triphenolmethane, triphenolethane, 1,1,1-tris(4-hydroxyphenyl)ethane, and tris(4-hydroxyphenyl)-1-ethyl-4-isopropylbenzene are preferred in terms of improvement in curability and film thickness uniformity of the metal-containing film. 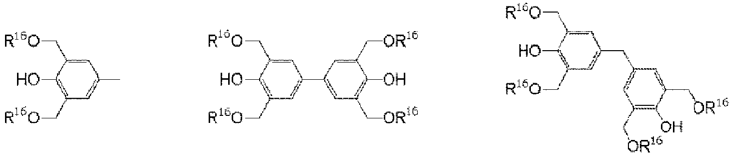 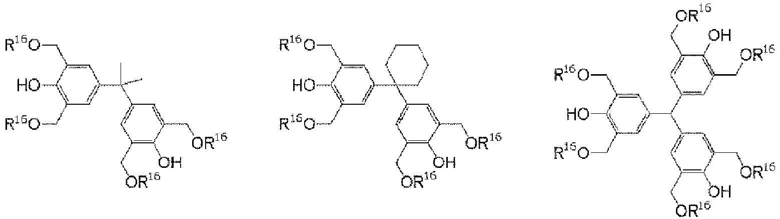 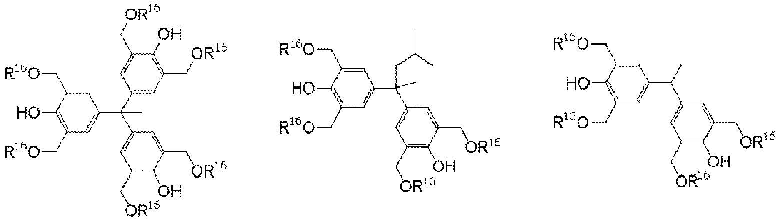 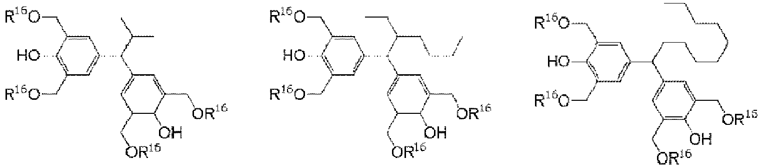 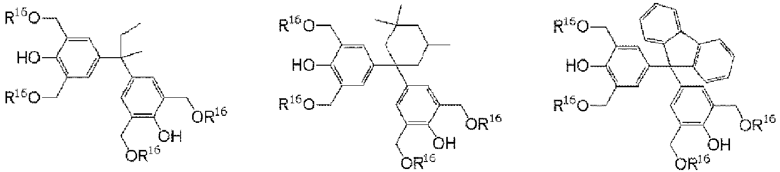 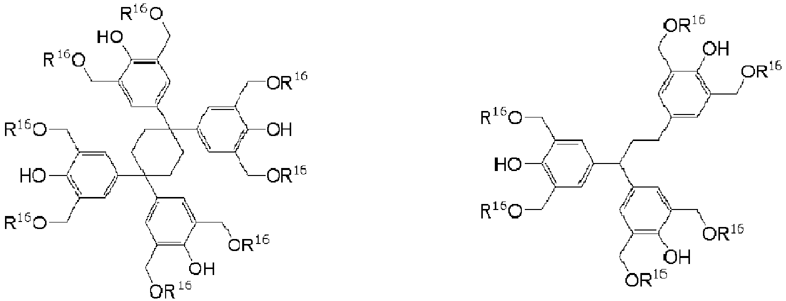 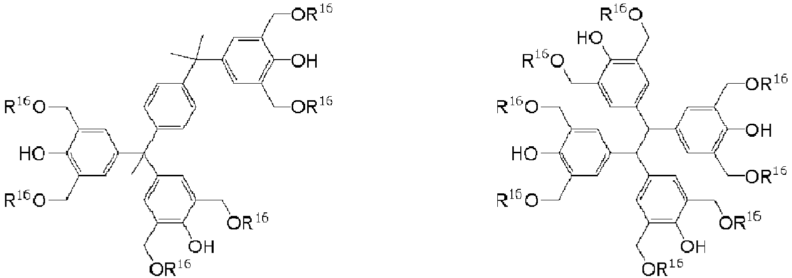 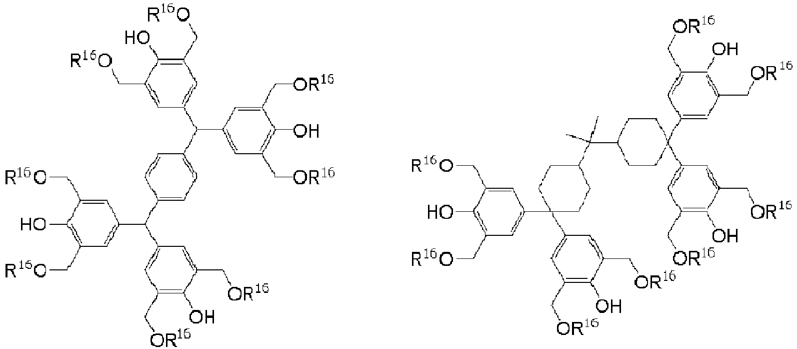 In the formulae, R¹⁶ is as defined above.

### <(D) Acid Generator>

The composition for forming a metal-containing film can include (D) an acid generator in order to further accelerate a curing reaction of the metal compound (A). The acid generator (D) includes those that generate an acid by thermal decomposition and those that generate an acid by light radiation. Any of these can be added. Specifically, the materials disclosed in paragraphs [0061] to [0085] in JP 2007-199653 A can be added, without limitation.

The above acid generators (D) can be used alone or in combination of two or more. When the acid generator (D) is added, the amount added is preferably 0.05 to 50 parts by mass, more preferably 0.1 to 10 parts by mass with respect to 100 parts by mass of the metal compound (A) .

### <(E) Surfactant>

(E) a surfactant can be added to the composition for forming a metal-containing film in order to improve the coating property in spin coating. For example, those disclosed in paragraphs [0142] to [0147] in JP 2009-269953 A can be used as the surfactant (E). When the surfactant (E) is added, the amount added is preferably 0.01 to 10 parts by mass, more preferably 0.05 to 5 parts by mass with respect to 100 parts by mass of the metal compound (A).

The multilayer reflective film layer preferably includes one or more layers, more preferably two or more layers, even more preferably three or more layers, and particularly preferably five or more layers of the metal-containing low refractive index film.

Such a multilayer reflective film layer can increase the refractive index for EUV light and therefore can further enhance the sensitivity of the resist upper layer film.

Depending on the number of layers of the low refractive index film in the multilayer reflective film layer, the number of layers of the paired high refractive index film also increases. In terms of etching processing, the relation between the number of layers "s" of the low refractive index film and the number of layers "m" of the high refractive index film in the multilayer reflective film layer is preferably "s"="m" or "s"<"m".

The low refractive index film preferably has a refractive index n of 0.97 or less, more preferably 0.965 or less, even more preferably 0.96 or less at the wavelength of the EUV light.

The multilayer reflective film layer including the low refractive index film with such a refractive index has a high reflectivity for EUV light and therefore can further enhance the sensitivity of the resist upper layer film.

The low refractive index film preferably has a film thickness of 10 nm or less, more preferably 8 nm or less, even more preferably 6 nm or less, particularly preferably 5 nm or less per layer. The lower limit of the film thickness is preferably 1 nm or more, more preferably 2 nm or more, even more preferably 3 nm or more.

The film thickness of the low refractive index film within the above range can further increase the reflectivity for EUV light.

The film thicknesses of the low refractive index film and the high refractive index film in the multilayer reflective film layer may be the same or different among layers. In order to increase the reflectivity, the film thickness of each layer of the low refractive index film is preferably the same.

It is preferable that at least one or more layers of an adhesive film are disposed between the resist upper layer film and the multilayer reflective film layer. The adhesive film is selected from: a silicon-containing hard mask film made of a material containing Si and one or more elements selected from nitrogen, carbon, hydrogen, and oxygen; and a carbon-containing hard mask film made of a material containing carbon and one or more elements selected from nitrogen, hydrogen, and oxygen.

It is preferable to dispose the adhesive film between the resist upper layer film and the multilayer reflective film layer in order to suppress pattern collapse of the resist.

As a composition of the adhesive film, it is preferable to use any one of: a silicon-containing hard mask film made of a material containing Si and one or more elements selected from nitrogen, carbon, hydrogen, and oxygen; and a carbon-containing hard mask film made of a material containing carbon and one or more elements selected from nitrogen, hydrogen, and oxygen.

The adhesive film preferably has a film thickness of 15 nm or less, more preferably 10 nm or less, even more preferably 8 nm or less, particularly preferably 5 nm or less.

It is preferable that the pattern forming method includes a step of transferring a pattern up to a layer to be processed on the substrate by dry etching while using the resist upper layer film having the pattern as a mask.

It is preferable that a high refractive index film made of a material containing carbon and one or more elements selected from nitrogen, hydrogen, and oxygen is immediately above the layer to be processed.

The high refractive index film containing carbon is preferably a material containing carbon and one or more elements selected from nitrogen, hydrogen, and oxygen, and the carbon content in the high refractive index film is preferably 60% by mass or more, more preferably 70% by mass or more, even more preferably 80% by mass or more, particularly preferably 85% by mass or more.

By using such a high refractive index film immediately above the layer to be processed, the resist pattern can be transferred to the layer to be processed with high accuracy. The high refractive index film containing carbon and one or more elements selected from nitrogen, hydrogen, and oxygen can be formed by a spin coating method, a PVD method, a CVD method, or an ALD method as described above.

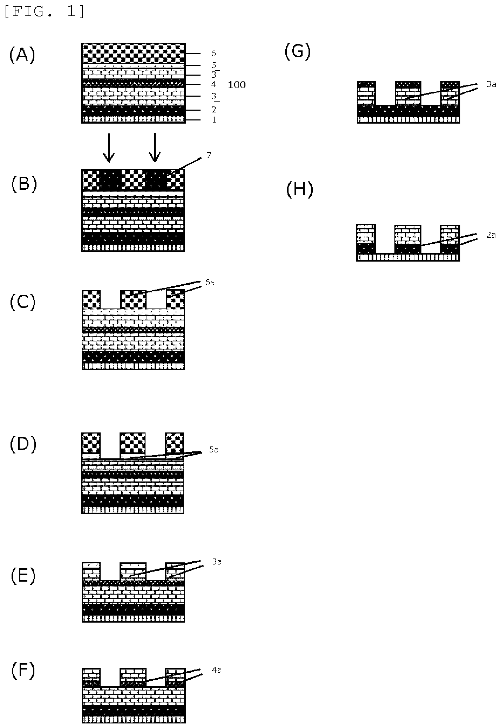

An example of the pattern forming method according to the present invention will be described using FIG. 1. In the present invention, as illustrated in FIG. 1(A), in a pattern forming method using a multilayer reflective film layer, a multilayer reflective film 100 is formed by: forming a high refractive index film 3 on a layer 2 to be processed on a substrate 1; forming a low refractive index film 4 different from the high refractive index film 3 in refractive index n at the wavelength of EUV light on the high refractive index film 3; and forming a high refractive index film 3 different from the low refractive index film 4 in refractive index n at the wavelength of EUV light on the low refractive index film 4. Subsequently, a resist upper layer film 6 is formed on the multilayer reflective film 100. It is preferable to form an adhesive film 5 in order to improve the effect of preventing resist film pattern collapse. Subsequently, as illustrated in FIG. 1(B), an exposure portion 7 of the resist upper layer film is patterned and exposed. Subsequently, as illustrated in FIG. 1(C), development is performed with a developer to form a resist upper layer film pattern 6a in the resist upper layer film.

Then, as illustrated in FIG. 1(D), using the resist upper layer film having a pattern as a mask, the pattern is transferred to the adhesive film by dry etching to form an adhesive film pattern 5a. Subsequently, as illustrated in FIG. 1(E), using the adhesive film having the transferred pattern as a mask, the pattern is transferred to the high refractive index film by dry etching to form a high refractive index film pattern 3a. Then, as illustrated in FIG. 1(F), using the high refractive index film having the pattern as a mask, the pattern is transferred to the low refractive index film by dry etching to form a low refractive index film pattern 4a. Then, as illustrated in FIG. 1(G), using the low refractive index film having the pattern as a mask, the pattern is transferred to the high refractive index film by dry etching to form a high refractive index film pattern 3a. Then, as illustrated in FIG. 1(H), using the high refractive index film having the pattern as a mask, the layer 2 to be processed is processed by dry etching to form a layer to be processed pattern 2a.

When a high refractive index film made of a material containing Si and one or more elements selected from nitrogen, carbon, hydrogen, and oxygen is used as the high refractive index film, the dry etching of the high refractive index film is preferably performed using a fluorine gas-based etching gas.

When a high refractive index film made of a material containing carbon and one or more elements selected from nitrogen, hydrogen, and oxygen is used as the high refractive index film, the dry etching of the high refractive index film is preferably performed using an oxygen gas-based etching gas.

The dry etching of the low refractive index film is preferably performed using a chlorine or bromine gas-based etching gas.

When the adhesive film is a silicon-containing hard mask film made of a material containing Si and one or more elements selected from nitrogen, carbon, hydrogen, and oxygen, the dry etching of the adhesive film is preferably performed using a fluorine gas-based etching gas.

When the adhesive film is a carbon-containing hard mask film made of a material containing carbon and one or more elements selected from nitrogen, hydrogen, and oxygen, the dry etching of the adhesive film is preferably performed using an oxygen gas-based etching gas.

The processing of the layer to be processed is preferably performed using a fluorine gas-based etching gas.

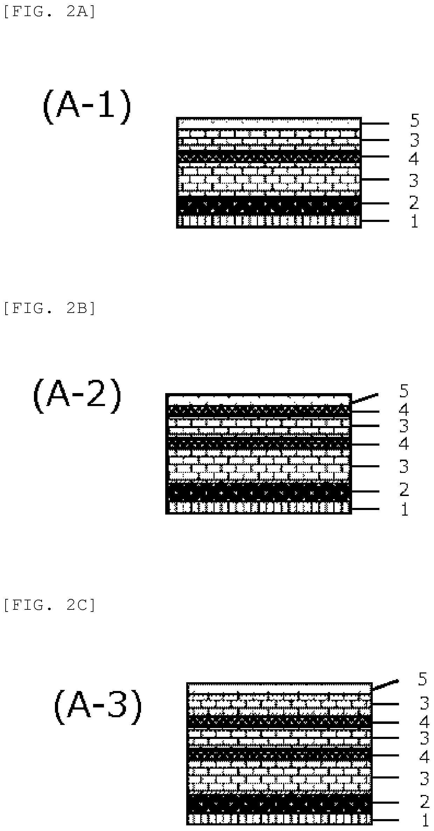

Specific examples of a multilayer structure including the multilayer reflective film layer that can be used in the pattern forming method according to the present invention include structures (A-1) to (A-4) in FIGs. 2A to 2D, but the present invention is not limited to these structures.

### EXAMPLE

Hereinafter, the present invention will be specifically described with reference to Examples and Comparative Examples. However, the present invention is not limited these examples.

### Pattern Forming Method and Calculation of Reflectivity

### (Examples 1-1 to 1-6, Comparative Example 1-1)

### <Pattern Forming Method 1 (Structure (A-1) in FIG. 2A)>

On a SiO₂ substrate 1 having the layer 2 to be processed,
(1) ODL-301 manufactured by Shin-Etsu Chemical Co., Ltd. was applied by a spin coating method, and the substrate heated at 350°C for 60 seconds was further heated in a nitrogen atmosphere (oxygen concentration 0.01%) at 500°C for 60 seconds to form the high refractive index film 3 with a film thickness 35 nm;
(2) a film of Mo alone (low refractive index film 4) with a film thickness of 4 nm was formed thereon by a sputtering method;
(3) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness 14 nm; and
(4) a silicon-containing resist middle layer film material (SOG-1) was applied thereon by a spin coating method and heated at 220°C for 60 seconds to form a silicon-containing resist middle layer film (adhesive film 5) with a film thickness of 5 nm.

As the silicon-containing resist middle layer film material (SOG-1), a polymer denoted as a silicon-containing middle layer film polymer (SiP1) and a crosslinking catalyst (CAT1) were dissolved in an organic solvent containing 0.1% by mass of FC-4430 (manufactured by Sumitomo 3M Limited) in the proportions listed in Table 1, and the solution was filtered through a fluorinated resin filter with a pore diameter of 0.1 um to prepare a silicon-containing resist middle layer film material (SOG-1).

**[Table 1]**

| | Polymer | Crosslinking catalyst | Organic solvent |
|---|---|---|---|
| | (Parts by mass) | (Parts by mass) | (Parts by mass) |
| SOG-1 | SiP1 (100) | CAT1 (1) | Propylene glycol monoethyl ether (4,000) |

The structural formulae of the silicon-containing middle layer film polymer (SiP1) and the crosslinking catalyst (CAT1) that were used are as follows.

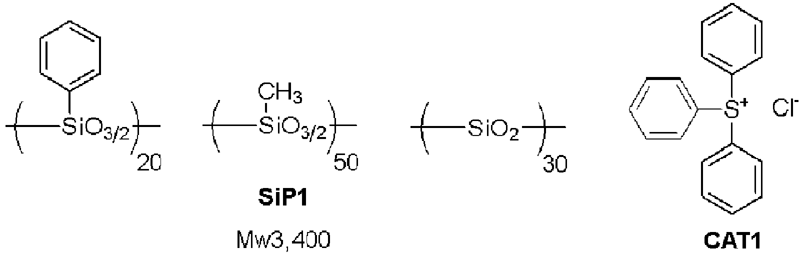

### <Pattern Forming Method 2 (Structure (A-2) in FIG. 2B)>

On a SiO₂ substrate 1 having the layer 2 to be processed,
(1) ODL-301 manufactured by Shin-Etsu Chemical Co., Ltd. was applied by a spin coating method, and the substrate heated at 350°C for 60 seconds was further heated in a nitrogen atmosphere (oxygen concentration 0.01%) at 500°C for 60 seconds to form the high refractive index film 3 with a film thickness of 35 nm;
(2) a film of Mo alone (low refractive index film 4) with a film thickness of 4 nm was formed thereon by a sputtering method;
(3) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(4) a film of Mo alone (low refractive index film 4) with a film thickness of 4 nm was formed thereon by a sputtering method; and
(5) a silicon-containing resist middle layer film material (SOG-1) was applied thereon by a spin coating method and heated at 220°C for 60 seconds to form a silicon-containing resist middle layer film (adhesive film 5) with a film thickness of 5 nm.

### <Pattern Forming Method 3 (Structure (A-3) in FIG. 2C)>

On a SiO₂ substrate 1 having the layer 2 to be processed,
(1) ODL-301 manufactured by Shin-Etsu Chemical Co., Ltd. was applied by a spin coating method, and the substrate heated at 350°C for 60 seconds was further heated in a nitrogen atmosphere (oxygen concentration 0.01%) at 500°C for 60 seconds to form the high refractive index film 3 with a film thickness of 35 nm;
(2) a bismuth-containing material (BiO-1) was applied thereon by a spin coating method and heated at 450°C for 60 seconds to form the low refractive index film 4 with a film thickness of 5 nm;
(3) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 15 nm;
(4) a bismuth-containing material (BiO-1) was applied thereon by a spin coating method and heated at 450°C for 60 seconds to form the low refractive index film 4 with a film thickness of 5 nm;
(5) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 15 nm; and
(6) a silicon-containing resist middle layer film material (SOG-1) was applied thereon by a spin coating method and heated at 220°C for 60 seconds to form a silicon-containing resist middle layer film (adhesive film 5) with a film thickness of 5 nm.

The bismuth-containing material (BiO-1) was prepared by dissolving bismuth(III) 2-ethylhexanoate in an organic solvent in the proportions shown in Table 2 and filtering the solution through a fluorinated resin filter with a pore diameter of 0.1 µm.

**[Table 2]**

| | Polymer | Organic solvent |
|---|---|---|
| | (Parts by mass) | (Parts by mass) |
| BiO-1 | Bismuth(III) 2-ethylhexanoate (10) | PGEE (100) |

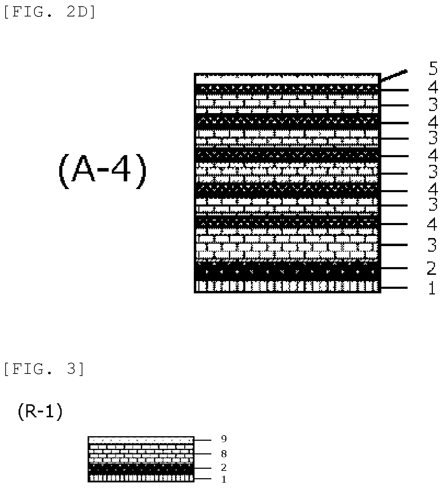

### <Pattern Forming Method 4 (Structure (A-4) in FIG. 2D)>

On a SiO₂ substrate 1 having the layer 2 to be processed,
(1) ODL-301 manufactured by Shin-Etsu Chemical Co., Ltd. was applied by a spin coating method, and the substrate heated at 350°C for 60 seconds was further heated in a nitrogen atmosphere (oxygen concentration 0.01%) at 500°C for 60 seconds to form the high refractive index film 3 with a film thickness of 35 nm;
(2) a bismuth-containing material (BiO-1) was applied thereon by a spin coating method and heated at 450°C for 60 seconds to form the low refractive index film 4 with a film thickness of 4 nm;
(3) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(4) a bismuth-containing material (BiO-1) was applied thereon by a spin coating method and heated at 450°C for 60 seconds to form the low refractive index film 4 with a film thickness of 4 nm;
(5) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(6) a bismuth-containing material (BiO-1) was applied thereon by a spin coating method and heated at 450°C for 60 seconds to form the low refractive index film 4 with a film thickness of 4 nm;
(7) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(8) a bismuth-containing material (BiO-1) was applied thereon by a spin coating method and heated at 450°C for 60 seconds to form the low refractive index film 4 with a film thickness of 4 nm;
(9) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(10) a bismuth-containing material (BiO-1) was applied thereon by a spin coating method and heated at 450°C for 60 seconds to form the low refractive index film 4 with a film thickness of 4 nm; and
(11) a silicon-containing resist middle layer film material (SOG-1) was applied thereon by a spin coating method and heated at 220°C for 60 seconds to form a silicon-containing resist middle layer film (adhesive film 5) with a film thickness of 5 nm.

### <Pattern Forming Method 5 (Structure (A-4) in FIG. 2D)>

On a SiO₂ substrate 1 having the layer 2 to be processed,
(1) ODL-301 manufactured by Shin-Etsu Chemical Co., Ltd. was applied by a spin coating method, and the substrate heated at 350°C for 60 seconds was further heated in a nitrogen atmosphere (oxygen concentration 0.01%) at 500°C for 60 seconds to form the high refractive index film 3 with a film thickness of 35 nm;
(2) a hafnium-containing material (HfO-1) was applied thereon by a spin coating method and heated at 450°C for 60 seconds to form the low refractive index film 4 with a film thickness of 4 nm;
(3) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(4) a hafnium-containing material (HfO-1) was applied thereon by a spin coating method and heated at 450°C for 60 seconds to form the low refractive index film 4 with a film thickness of 4 nm;
(5) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(6) a hafnium-containing material (HfO-1) was applied thereon by a spin coating method and heated at 450°C for 60 seconds to form the low refractive index film 4 with a film thickness of 4 nm;
(7) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(8) a hafnium-containing material (HfO-1) was applied thereon by a spin coating method and heated at 450°C for 60 seconds to form the low refractive index film 4 with a film thickness of 4 nm;
(9) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(10) a hafnium-containing material (HfO-1) was applied thereon by a spin coating method and heated at 450°C for 60 seconds to form the low refractive index film 4 with a film thickness of 4 nm; and
(11) a silicon-containing resist middle layer film material (SOG-1) was applied thereon by a spin coating method and heated at 220°C for 60 seconds to form a silicon-containing resist middle layer film (adhesive film 5) with a film thickness of 5 nm.

The hafnium-containing material (HfO-1) was prepared by dissolving a hafnium-containing polymer (HfP1) synthesized as follows in an organic solvent in the proportions shown in Table 3 and filtering the solution through a fluorinated resin filter with a pore diameter of 0.1 um.

### (Synthesis of Hafnium-Containing Polymer (HfP1))

In a nitrogen atmosphere, a solution of 1.6 g of deionized water and 54.5 g of n-butanol was added dropwise to 40.5 g of a n-butanol solution of 54.4 g of hafnium(IV) n-butoxide under stirring at room temperature over two hours. To the resulting solution, 17.4 g of allyl acetoacetate was added, and the solution was stirred at room temperature for 30 minutes. The solution was concentrated under a reduced pressure at 30°C, and then heated to 60°C, and kept heated under a reduced pressure until no distillate was produced. When no distillate was found, 69.0 g of a PGMEA/PGME (mass ratio 70/30) solution was added, and the solution was heated at 40°C under a reduced pressure until no IPA was distilled, resulting in a PGMEA/PGME solution of the hafnium-containing polymer (HfP1). The concentration of components other than the solvent in the solution was 16% by mass.

**[Table 3]**

| | Polymer | Organic solvent |
|---|---|---|
| | (Parts by mass) | (Parts by mass) |
| HfO-1 | HfP1 (10) | PGMEA/PGME (70/30) |

### <Pattern Forming Method 6 (Structure (A-4) in FIG. 2D)>

On a SiO₂ substrate 1 having the layer 2 to be processed,
(1) ODL-301 manufactured by Shin-Etsu Chemical Co., Ltd. was applied by a spin coating method, and the substrate heated at 350°C for 60 seconds was further heated in a nitrogen atmosphere (oxygen concentration 0.01%) at 500°C for 60 seconds to form the high refractive index film 3 with a film thickness 35 nm;
(2) a molybdenum-containing material (MoO-1) was applied thereon by a spin coating method and heated at 450°C for 60 seconds to form the low refractive index film 4 with a film thickness of 4 nm;
(3) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(4) a molybdenum-containing material (MoO-1) was applied thereon by a spin coating method and heated at 450°C for 60 seconds to form the low refractive index film 4 with a film thickness of 4 nm;
(5) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(6) a molybdenum-containing material (MoO-1) was applied thereon by a spin coating method and heated at 450°C for 60 seconds to form the low refractive index film 4 with a film thickness of 4 nm;
(7) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(8) a molybdenum-containing material (MoO-1) was applied thereon by a spin coating method and heated at 450°C for 60 seconds to form the low refractive index film 4 with a film thickness of 4 nm;
(9) ODL-301 was applied thereon by a spin coating method, and the substrate heated at 350°C for 60 seconds was further heated in a nitrogen atmosphere (oxygen concentration 0.01%) at 500°C for 60 seconds to form the high refractive index film 3 with a film thickness of 10 nm;
(10) a molybdenum-containing material (MoO-1) was applied thereon by a spin coating method and heated at 450°C for 60 seconds to form the low refractive index film 4 with a film thickness of 4 nm; and
(11) a silicon-containing resist middle layer film material (SOG-1) was applied thereon by a spin coating method and heated at 220°C for 60 seconds to form a silicon-containing resist middle layer film (adhesive film 5) with a film thickness of 5 nm.

The molybdenum-containing material (MoO-1) was prepared by dissolving bis(acetylacetonato)dioxomolybdenum(VI) in an organic solvent in the proportions shown in Table 4 and filtering the solution through a fluorinated resin filter with a pore diameter of 0.1 um.

**[Table 4]**

| | Polymer | Organic solvent |
|---|---|---|
| | (Parts by mass) | (Parts by mass) |
| MoO-1 | Bis(acetylacetonato) dioxomolybdenum(VI) (10) | PGEE (100) |

### <Comparative Pattern Forming Method 1 (Structure (R-1) in FIG. 3)>

On a SiO₂ substrate 1 having the layer 2 to be processed,
(1) ODL-301 manufactured by Shin-Etsu Chemical Co., Ltd. was applied by a spin coating method, and the substrate heated at 350°C for 60 seconds was further heated in a nitrogen atmosphere (oxygen concentration 0.01%) at 500°C for 60 seconds to form a high refractive index film 8 with a film thickness of 35 nm; and
(2) a silicon-containing resist middle layer film material (SOG-1) was applied thereon by a spin coating method and heated at 220°C for 60 seconds to form a silicon-containing resist middle layer film (adhesive film 9) with a film thickness of 10 nm.

In calculation of the refractive index n and the extinction coefficient k of each film at EUV light, a web page <http://henke.lbl.gov/optical_constants/getdb2.html> from CXRO (The Center for X-ray Optics) was used. The results are listed in Table 5.

**[Table 5]**

| Film-forming material | Refractive index n (13.5 nm) | Extinction coefficient k (13.5 nm) |
|---|---|---|
| ODL-301 | 0.977 | 0.004 |
| SOG-1 | 0.983 | 0.006 |
| Mo | 0.926 | 0.006 |
| BiO-1 | 0.938 | 0.053 |
| HfO-1 | 0.962 | 0.024 |
| MoO-1 | 0.948 | 0.015 |

The following photoresist material prepared in the composition shown in Table 6 was applied on the adhesive film prepared as described above to form a photoresist film with a film thickness of 40 nm. Subsequently, the reflectivity of EUV light from the multilayer reflective film layer to the photoresist film in EUV exposure of the photoresist film (NA 0.33, σ 0.8/0.5, hexapole illumination) was calculated. The reflectivity was calculated using PROLITH 2020a (Litho Tech Japan Corporation). The results are listed in Table 7.

**[Table 6]**

| Component | Polymer | Quencher | Sensitizer | Surfactant | Organic solvent |
|---|---|---|---|---|---|
| Composition (Parts by mass) | (100) | (4.0) | (2.1) | (0.25) | PGMEA (400) |
| | | | | | CyHO (2000) |
| | | | | | PGME (100) |

The polymer, quencher, sensitizer, surfactant, and organic solvent used in the photoresist material are as follows. 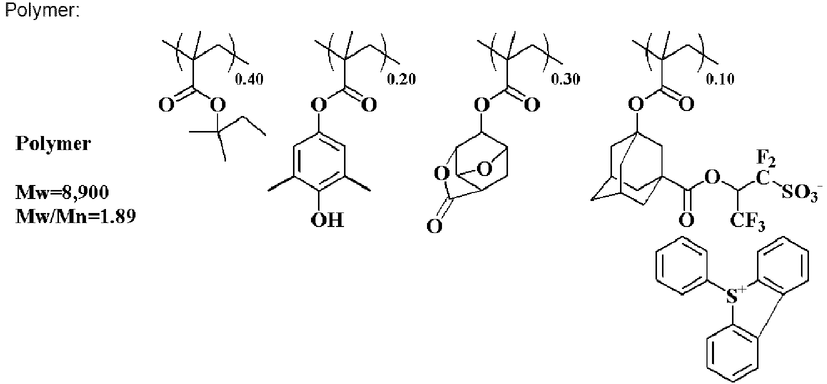 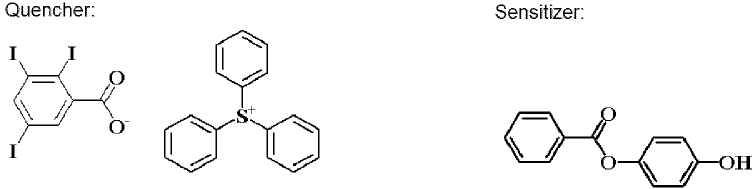
- Surfactant: FC-4430 manufactured by 3M Company
- Organic solvent: PGMEA (propylene glycol monomethyl ether acetate)
   CyHO (cyclohexanone)
   PGME (propylene glycol monomethyl ether)

**[Table 7]**

| | Pattern forming method | Reflectivity(%) |
|---|---|---|
| Example 1-1 | Pattern forming method 1 | 0.42% |
| Example 1-2 | Pattern forming method 2 | 1.45% |
| Example 1-3 | Pattern forming method 3 | 0.52% |
| Example 1-4 | Pattern forming method 4 | 2.76% |
| Example 1-5 | Pattern forming method 5 | 1. 05% |
| Example 1-6 | Pattern forming method 6 | 1.82% |
| Comparative Example 1-1 | Comparative pattern forming method 1 | 0.02% |

As indicated in Table 7, the pattern forming method according to the present invention (Examples 1-1 to 1-6) achieved high reflection of EUV light compared with the conventional tri-layer structure (Comparative Example 1-1). In particular, it was found that a high reflectivity was achieved when the multilayer reflective film layer includes two or more layers of the metal-containing film serving as a low refractive index film (comparison between Example 1-1 and Example 1-2 and between Example 1-3 and Example 1-4).

### EUV lithography Evaluation (Examples 2-1 to 2-3,

### Comparative Example 2-1)

The photoresist material used in Example 1 was applied on the adhesive film prepared by the above pattern forming method to form a photoresist film with a film thickness of 40 nm. Subsequently, the photoresist film was subjected to EUV exposure (NA 0.33, σ 0.8/0.5, hexapole illumination), PEB on a hot plate at 100°C for 60 seconds, and development with an aqueous solution of 2.38% by mass of TMAH for 30 seconds, resulting in a hole pattern with a dimension of 23 nm.

A critical dimension SEM (CG5000) manufactured by Hitachi High-Technologies Corporation was used to determine the exposure dose for forming a hole dimension of 23 nm, and the determined value was considered as sensitivity. In addition, the dimensions of 50 holes were measured and critical dimension uniformity (CDU, 3σ) was determined. The results are listed in Table 8.

**[Table 8]**

| Example | Pattern forming method | Patterning test | |
|---|---|---|---|
| | | Sensitivity (mJ/cm²) | CDU (nm) |
| Example 2-1 | Pattern forming method 3 | 28 | 3.1 |
| Example 2-2 | Pattern forming method 4 | 23 | 3.2 |
| Example 2-3 | Pattern forming method 5 | 26 | 3.2 |
| Comparative Example 2-1 | Comparative pattern forming method 1 | 30 | 3.2 |

As indicated in Table 8, the pattern forming method according to the present invention (Examples 2-1 to 2-3) was able to form a pattern with high sensitivity without degradation of CDU, compared with the conventional tri-layer structure (Comparative Example 2-1). Presumably, reflection of EUV light from the multilayer reflective film layer to the photoresist film enhanced the sensitivity of the resist.

As described above, the present invention provides a pattern forming method that can overcome the tradeoff between the sensitivity and LWR and can contribute to sensitivity enhancement while maintaining LWR of the resist upper layer film and a laminate. Therefore, the present invention is useful in the field of EUV lithography.

The present description includes the following embodiments.
[1] : A pattern forming method using EUV lithography, the pattern forming method comprising steps of:
   forming a resist upper layer film on at least one surface side of a substrate;
   irradiating the resist upper layer film with EUV light; and
   developing the resist upper layer film to form a pattern, wherein
   a multilayer reflective film layer is disposed between the substrate and the resist upper layer film, and
   the multilayer reflective film layer has a structure in which two or more materials different in refractive index n at a wavelength of the EUV light are alternately laminated.
[2]: The pattern forming method according to the above [1], wherein the multilayer reflective film layer includes a structure in which two or more materials different in refractive index n by 0.01 or more at a wavelength of the EUV light are alternately laminated.
[3]: The pattern forming method according to the above [1] or [2], wherein the multilayer reflective film layer comprises: one layer or two or more layers of a high refractive index film comprising a material comprising Si and one or more elements selected from nitrogen, carbon, hydrogen, and oxygen; and one layer or two or more layers of a low refractive index film comprising a material comprising any one or more metals of Ti, Cr, Ni, Zr, Nb, Mo, Ru, Rh, Hf, Ta, W, and Bi.
[4]: The pattern forming method according to the above [1] or [2], wherein the multilayer reflective film layer comprises: one layer or two or more layers of a high refractive index film comprising a material comprising carbon and one or more elements selected from nitrogen, hydrogen, and oxygen; and one layer or two or more layers of a low refractive index film comprising a material comprising any one or more metals of Ti, Cr, Ni, Zr, Nb, Mo, Ru, Rh, Hf, Ta, W, and Bi.
[5]: The pattern forming method according to the above [1] or [2], wherein the multilayer reflective film layer comprises two or more layers of a low refractive index film comprising a material comprising any one or more metals of Ti, Cr, Ni, Zr, Nb, Mo, Ru, Rh, Hf, Ta, W, and Bi.
[6]: The pattern forming method according to any one of the above [3] to [5], wherein the low refractive index film has a refractive index n of 0.97 or less at a wavelength of the EUV light.
[7]: The pattern forming method according to any one of the above [3] to [6], wherein the low refractive index film has a film thickness of 10 nm or less per layer.
[8]: The pattern forming method according to any one of the above [1] to [7], wherein at least one or more layers of an adhesive film are disposed between the resist upper layer film and the multilayer reflective film layer, the adhesive film being selected from: a silicon-containing hard mask film comprising a material comprising Si and one or more elements selected from nitrogen, carbon, hydrogen, and oxygen; and a carbon-containing hard mask film comprising a material comprising carbon and one or more elements selected from nitrogen, hydrogen, and oxygen.
[9]: The pattern forming method according to any one of the above [1] to [8], further comprising a step of transferring a pattern up to a layer to be processed on the substrate by dry etching while using the resist upper layer film having the pattern as a mask.
[10]: A laminate comprising: a substrate to be processed in which a pattern is to be formed; a multilayer reflective film layer on the substrate to be processed; and a resist upper layer film on the multilayer reflective film layer, wherein the multilayer reflective film layer has a structure in which two or more materials different in refractive index n at a wavelength of EUV light are alternately laminated.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A pattern forming method using EUV lithography, the pattern forming method comprising steps of:
forming a resist upper layer film on at least one surface side of a substrate;
irradiating the resist upper layer film with EUV light; and
developing the resist upper layer film to form a pattern, wherein
a multilayer reflective film layer is disposed between the substrate and the resist upper layer film, and
the multilayer reflective film layer has a structure in which two or more materials different in refractive index n at a wavelength of the EUV light are alternately laminated.

2. The pattern forming method according to claim 1, wherein the multilayer reflective film layer includes a structure in which two or more materials different in refractive index n by 0.01 or more at a wavelength of the EUV light are alternately laminated.

3. The pattern forming method according to claim 1 or 2, wherein the multilayer reflective film layer comprises: one layer or two or more layers of a high refractive index film comprising a material comprising Si and one or more elements selected from nitrogen, carbon, hydrogen, and oxygen; and one layer or two or more layers of a low refractive index film comprising a material comprising any one or more metals of Ti, Cr, Ni, Zr, Nb, Mo, Ru, Rh, Hf, Ta, W, and Bi.

4. The pattern forming method according to claim 1 or 2, wherein the multilayer reflective film layer comprises: one layer or two or more layers of a high refractive index film comprising a material comprising carbon and one or more elements selected from nitrogen, hydrogen, and oxygen; and one layer or two or more layers of a low refractive index film comprising a material comprising any one or more metals of Ti, Cr, Ni, Zr, Nb, Mo, Ru, Rh, Hf, Ta, W, and Bi.

5. The pattern forming method according to claim 1 or 2, wherein the multilayer reflective film layer comprises two or more layers of a low refractive index film comprising a material comprising any one or more metals of Ti, Cr, Ni, Zr, Nb, Mo, Ru, Rh, Hf, Ta, W, and Bi .

6. The pattern forming method according to any one of claims 3 to 5, wherein the low refractive index film has a refractive index n of 0.97 or less at a wavelength of the EUV light.

7. The pattern forming method according to any one of claims 3 to 6, wherein the low refractive index film has a film thickness of 10 nm or less per layer.

8. The pattern forming method according to any one of claims 1 to 7, wherein at least one or more layers of an adhesive film are disposed between the resist upper layer film and the multilayer reflective film layer, the adhesive film being selected from: a silicon-containing hard mask film comprising a material comprising Si and one or more elements selected from nitrogen, carbon, hydrogen, and oxygen; and a carbon-containing hard mask film comprising a material comprising carbon and one or more elements selected from nitrogen, hydrogen, and oxygen.

9. The pattern forming method according to any one of claims 1 to 8, further comprising a step of transferring a pattern up to a layer to be processed on the substrate by dry etching while using the resist upper layer film having the pattern as a mask.

10. A laminate comprising: a substrate to be processed in which a pattern is to be formed; a multilayer reflective film layer on the substrate to be processed; and a resist upper layer film on the multilayer reflective film layer, wherein the multilayer reflective film layer has a structure in which two or more materials different in refractive index n at a wavelength of EUV light are alternately laminated.
